# EUROPEAN PATENT APPLICATION

(11) **EP 4 645 594 A1**
(43) Date of publication of application: **05.11.2025**
(21) Application number: 23912096.7
(22) Date of filing: 26.12.2023
(51) Int. Cl.: H01Q 1/40, H01P 3/12, H05K 3/46

(54) **PRINTED WIRING BOARD AND METHOD FOR MANUFACTURING PRINTED WIRING BOARD**

(30) Priority: 28.12.2022 JP 2022212268
(71) Applicant: Kyocera Corporation, Kyoto-shi, Kyoto 612-8501 (JP)
(72) Inventor: KAWAGOE Atsuo, Kyoto-shi, Kyoto 612-8501 (JP); ISHIOKA Takashi, Kyoto-shi, Kyoto 612-8501 (JP)
(74) Representative: Viering, Jentschura & Partner mbB Patent- und Rechtsanwälte
(86) International application number: PCT/JP2023/046544
(87) International publication number: WO 2024/143317

(57) **Abstract**

A printed wiring board includes: a core substrate including a through hole in a slotted hole shape in plan view; and a through conductor located in the through hole. The through hole includes: pared end portions located at both ends of the through hole in a longitudinal direction of the through hole in plan view; and an intermediate portion located between the paired end portions. The intermediate portion includes, at least in part in the longitudinal direction, first side walls having stepped shapes facing each other in a cross-sectional view perpendicular to the longitudinal direction, and a distance between the first side walls facing each other decreases as a distance to a center of the core substrate in a thickness direction decreases in a through-thickness direction of the through hole.

## Description

### TECHNICAL FIELD

The present disclosure relates to a printed wiring board and a method for manufacturing a printed wiring board.

### BACKGROUND OF INVENTION

A printed wiring board having a waveguide tube structure includes a shield structure that enables electromagnetic waves to propagate appropriately in a waveguide portion of the waveguide tube structure and reduces the leakage of electromagnetic waves to the surrounding regions. The shield structure in a core substrate can be achieved by multiple through-hole conductors arranged with appropriate gaps in between in the plane direction of the waveguide portion. In this case, the through-hole conductor is formed on the inner wall of each through hole extending through the core substrate and electrically connected to ground conductor layers located between multiple insulating layers.

As the through hole, a cylindrical shape in plan view is easy to form. In Japanese Patent No. 6105496, the loss of electromagnetic waves related to the propagation is reduced by through holes having diameters and gaps according to the wavelength of electromagnetic waves that propagate in the waveguide portion. However, such a shield structure does not provide sufficient effects to reduce the leakage of electromagnetic waves. To address this, through holes having slotted hole shapes have been proposed.

### SUMMARY

In the present disclosure, an aspect of a printed wiring board includes: a core substrate including a through hole in a slotted hole shape in plan view; and a through conductor located in the through hole. The through hole includes: pared end portions located at both ends of the through hole in a longitudinal direction of the through hole in plan view; and an intermediate portion located between the paired end portions, the intermediate portion includes, at least in part in the longitudinal direction, first side walls of the through hole having stepped shapes facing each other in a cross-sectional view perpendicular to the longitudinal direction, and a distance between the first side walls facing each other decreases as a distance to a center of the core substrate in a thickness direction decreases in a through-thickness direction.

In the present disclosure, an aspect of a method for manufacturing a printed wiring board includes: removing, from a first insulating plate covered with first conductor layers on both sides, coverings of the first conductor layers, in first regions having a first width and elongated in a same position in transparent plan view; removing, from two second insulating plates each including one surface covered with a second conductor layer and a surface opposite to the one surface and covered with a third conductor layer, coverings of the second conductor layers, in elongated second regions having a second width larger than the first width; removing coverings of the third conductor layers from the two second insulating plates, in third regions having a third width larger than the second width and encompassing the second regions in transparent plan view; forming a multilayer body by joining each of the second conductor layers to one of the first conductor layers with an insulating layer in between in a state in which a positional relationship of the second regions encompassing the first regions in transparent plan view is kept; forming through holes by drilling at both ends of the third regions in the multilayer body; forming first holes that extend through the second insulating plates by laser in accordance with the third regions; forming second holes that extend through the insulating layers by laser in accordance with the second regions; forming a third hole that extends through the first insulating plate by laser in accordance with the first regions; and attaching a through conductor to the first holes, the second holes, the third hole, and the through holes.

In the present disclosure, another aspect of a method for manufacturing a printed wiring board includes: forming an elongated first through hole having a first width by drilling in a first insulating plate covered with first conductor layers on both sides; forming an elongated second through hole having a second width larger than the first width by drilling in each of two second insulating plates each covered with second conductor layers on both sides; forming a multilayer body by joining one of the second conductor layers of each second insulating plate to one of the first conductor layers with an insulating layer in between, in a state in which a positional relationship of the second through holes encompassing the first through hole in transparent plan view is kept, and filling an inside of the first through hole and insides of the second through holes with the insulating layer; forming third through holes in the multilayer body by drilling at both ends of the second through holes; forming first holes that extend through the second insulating plates and the insulating layers by laser in accordance with ranges of the second through holes; forming a second hole that extends through the first insulating plate by laser in accordance with a range of the first through hole; and attaching a through conductor to the first holes, the second hole, and the third through holes.

### BRIEF DESCRIPTION OF THE DRAWINGS

FIG. 1A is a plan view of a phased array antenna board including a core substrate, from above.
FIG. 1B is a cross-sectional view of a patch antenna included in the phased array antenna board.
FIG. 2A is a plan view of a through hole.
FIG. 2B illustrates cross-sectional views of the through hole.
FIG. 3 is a plan view of an upper surface of a printed wiring board.
FIG. 4A is a diagram for explaining the procedure of a first method for manufacturing a through hole.
FIG. 4B is a diagram for explaining the procedure of the first method for manufacturing the through hole.
FIG. 4C is a diagram for explaining the procedure of the first method for manufacturing the through hole.
FIG. 5A is a diagram for explaining the procedure of the first method for manufacturing the through hole.
FIG. 5B is a diagram for explaining the procedure of the first method for manufacturing the through hole.
FIG. 5C is a diagram for explaining the procedure of the first method for manufacturing the through hole.
FIG. 6A is a diagram for explaining the procedure of the first method for manufacturing the through hole.
FIG. 6B is a diagram for explaining the procedure of the first method for manufacturing the through hole.
FIG. 6C is a diagram for explaining the procedure of the first method for manufacturing the through hole.
FIG. 7A is a plan view of a through hole of a second example.
FIG. 7B illustrates cross-sectional views of the through hole of the second example.
FIG. 8A is a diagram for explaining the procedure of a second method for manufacturing a through hole.
FIG. 8B is a diagram for explaining the procedure of the second method for manufacturing the through hole.
FIG. 8C is a diagram for explaining the procedure of the second method for manufacturing the through hole.
FIG. 9A is a diagram for explaining the procedure of the second method for manufacturing the through hole.
FIG. 9B is a diagram for explaining the procedure of the second method for manufacturing the through hole.
FIG. 9C is a diagram for explaining the procedure of the second method for manufacturing the through hole.
FIG. 10A is a diagram for explaining the procedure of the second method for manufacturing the through hole.
FIG. 10B is a diagram for explaining the procedure of the second method for manufacturing the through hole.
FIG. 11A is a plan view of a through hole of a third example.
FIG. 11B illustrates cross-sectional views of a through hole of a fourth example.

### DESCRIPTION OF EMBODIMENTS

Hereinafter, embodiments will be described with reference to the drawings.

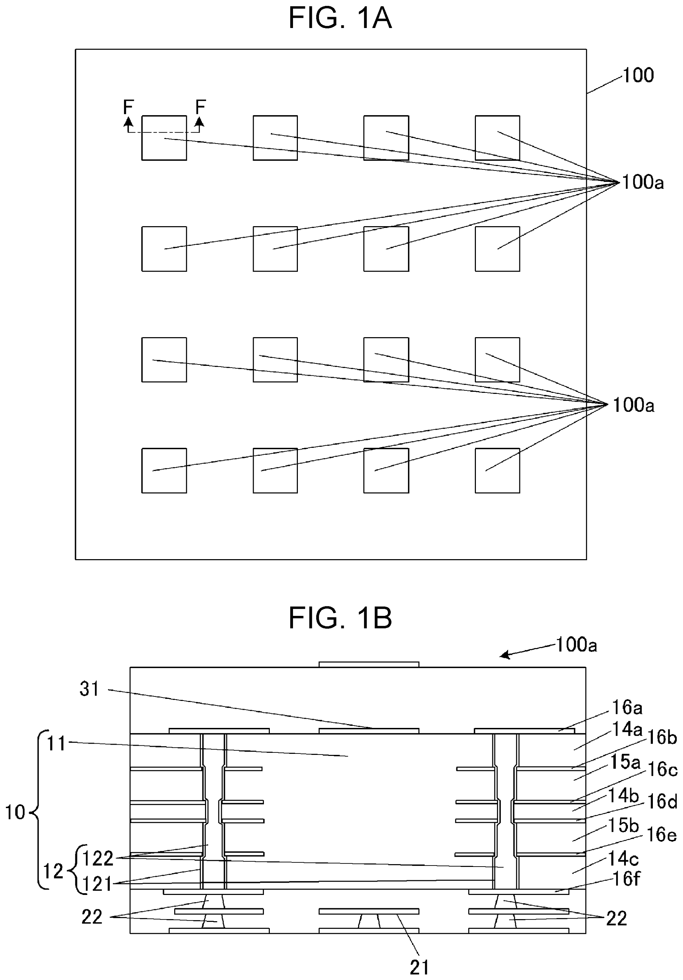

FIGs. 1A and 1B are diagrams for explaining a phased array antenna board 100 which is a printed wiring board of the present embodiment. FIG. 1A is a plan view of the phased array antenna board 100 including a core substrate 10, from above. FIG. 1B is a cross-sectional view of a patch antenna 100a included in the phased array antenna board 100, taken along cross-section line FF.

As illustrated in FIG. 1A, the phased array antenna board 100 includes multiple patch antennas 100a arranged in a two-dimensional matrix. The phased array antenna board 100 is capable of determining the direction of the transmission and reception of electromagnetic waves by adjusting the phase differences in signals between the patch antennas 100a.

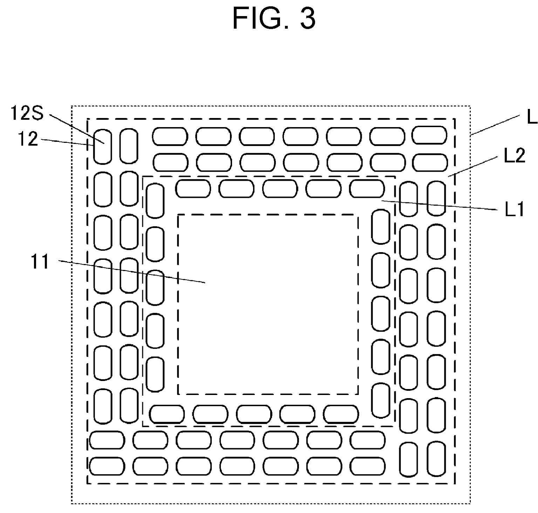

As illustrated in FIG. 1B, when the patch antenna 100a performs electromagnetic wave transmission, an electromagnetic wave emitted from a resonator 21 (an antenna) located below passes through a waveguide portion 11 of the core substrate 10 and through an emission pad 31 and is emitted upward. As illustrated in FIG. 3, the waveguide portion 11 is a rectangular range in plan view and has a shield structure 12S around it. The waveguide portion 11 and the shield structure 12S form a waveguide tube structure. The resonator 21 is connected to an IC chip (board) or the like (not illustrated) located on the bottom surface side of the phased array antenna board 100. The IC chip transmits a modulated signal (RF signal) having an appropriate phase difference to each patch antenna 100a, so that an electromagnetic wave (radio wave) including the signal is transmitted in the direction corresponding to the phase difference.

The core substrate 10 includes multiple stacked insulating layers 14a, 15a, 14b, 15b, and 14c and conductor layers 16a to 16f located between the insulating layers, on an upper surface of the uppermost insulating layer 14a, and on a lower surface of the lowermost insulating layer 14c. The insulating layers 14a to 14c, 15a, and 15b are each composed of an insulating material, which may contain reinforcement and inorganic fillers and may be one of the well-known various insulating materials used in the core substrate 10. The inside of the waveguide portion 11 is composed of a resin. This resin is the same as that used for the insulating layers 14a to 14c, 15a, and 15b.

The shield structure 12S includes a through-hole conductor 121 (a through conductor) located along a side wall surface (a side wall) of each through hole 120 extending through the core substrate 10, and an insulating resin 122 is located on the inner side surrounded by the through-hole conductor 121. The through-hole conductor 121 may be composed of, for example, copper. The insulating resin 122 is composed of a resin the same as or different from that of the insulating layers 14a to 14c, 15a, and 15b and the waveguide portion 11.

The conductor layers 16b to 16e are exposed inside the through hole 120 from between the insulating layers and are electrically connected to the through-hole conductor 121. The conductor layer 16a to 16f each serve as a ground plane (a ground conductor layer). Hence, the through-hole conductor 121 is also a ground plane electrically connected to these conductor layers. The through-hole conductor 121 is connected to a conductor via 22 at a lower portion and is thus connected to an external ground or the like.

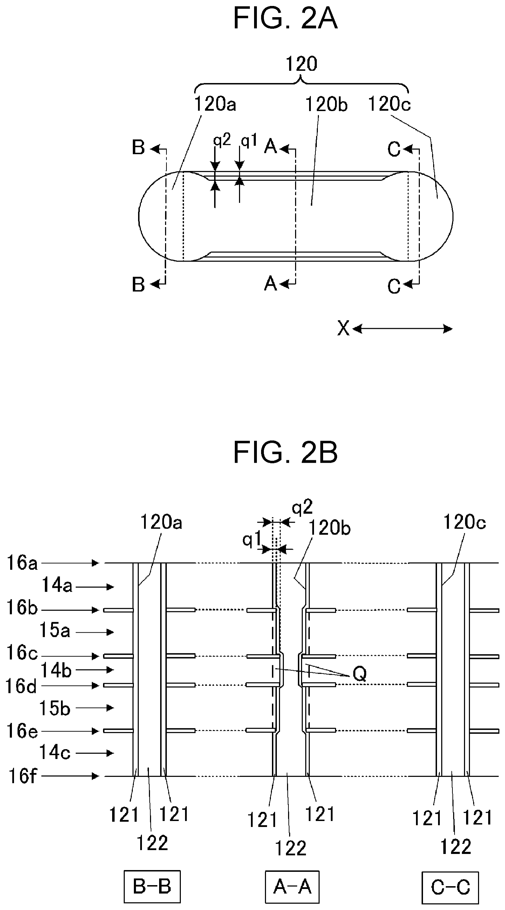

FIG. 2A is a plan view of the through hole 120 which is a first example. FIG. 2B illustrates cross-sectional views of the through-hole conductor 121 provided in this plan view (the through hole 120), taken along cross-section lines AA, BB, and CC.

As illustrated in FIG. 2A, the through hole 120 has a slotted hole shape elongated in the X direction in plan view. At both ends of the slotted hole are pared end portions 120a and 120c, each of which may be semicircular in plan view. Between the end portions 120a and 120c is an intermediate portion 120b connecting these end portions 120a and 120c, and the intermediate portion 120b has a rectangular shape having opening edges extending linearly in the X direction (in a straight line shape) in plan view.

As illustrated in FIGs. 1A and 1B, in a cross section (in a cross-sectional view) taken along cross-section line AA perpendicular to the longitudinal direction of the intermediate portion 120b, each of the side walls (first side walls) of the through hole 120 (the intermediate portion 120b) on both sides facing each other has a stepped shape (at least in part), so that the step surfaces can be seen in plan view. In an embodiment, two step surfaces can be seen. The width of the first step surface from the opening edge is q1, and the width of both the first step surface and the second step surface from the opening edge is q2. In contrast, in the cross-sections of the end portions 120a and 120c, taken along cross-section lines BB and CC perpendicular to the elongation direction of the slotted hole (the X direction), the side walls (second side walls) of the through hole 120 (the end portions 120a and 120c) facing each other are in the shapes of parallel straight lines (line shapes facing each other). In other words, step surfaces cannot be seen in plan view, and the side wall surface of each of the end portions 120a and 120c has a semicircular cylindrical shape in a perspective view, which is not illustrated. As illustrated in FIG. 2B, the distance of the inner side surfaces (the through-hole conductors 121) facing each other at cross-section line BB is constant.

In the core substrate 10, the through hole 120 (the intermediate portion 120b) has portions where the width of the side walls decreases stepwise at the positions of the conductor layers 16b to 16e, and the width decreases as the distance to the center of the core substrate 10 in the stacking direction decreases. In other words, the width of the intermediate portion 120b is smallest at the position corresponding to the insulating layer 14b located at the center.

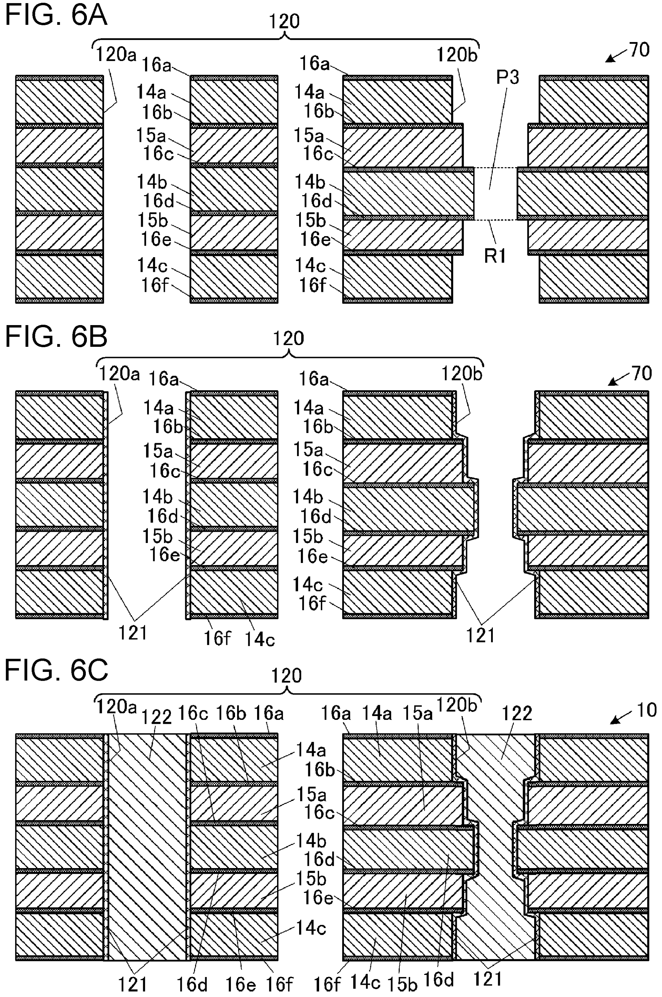

In other words, the insulating layers 14b, 15a, and 15b (the first insulating layer 14b and multiple insulating layers 15a and 15b) have protruding regions Q (first protruding regions) protruding from the positions of the side walls at the insulating layers 14a and 14c (the opening edges of the through hole 120) toward the center in the direction perpendicular to the elongation direction of the slotted hole (the X direction). At the boundaries between the insulating layers 14a and 14c and the first insulating layer 14b as mentioned above and the boundaries between the protruding regions having different protrusion widths, the conductor layers 16b to 16e (a first conductor layer and multiple conductor layers) extend from the positions of the side walls at the insulating layers 14a and 14c (the opening edges of the through hole 120) to the protruding regions Q on the side that protrude more (see FIGs. 6A to 6C described later and other figures). Note that the protrusion width of the protruding region of each portion in the same insulating layer (for example, the protrusion widths on the right and left sides of the insulating layers 14b, 15a, and 15b in FIG. 2B) may be different.

FIG. 3 is a transparent plan view of the waveguide portion 11 and its surroundings in the core substrate 10 of the printed wiring board (the phased array antenna board 100). In a region L surrounding the area of the waveguide portion 11 at the center, multiple slotted through holes 12 (through holes 120 and through-hole conductors 121 located inside) each having a slotted hole shape in plan view are aligned and function as the shield structure 12S. In the region L, the elongation (longitudinal) direction X of the slotted hole of each slotted through hole 12 extends in the direction parallel to the outer periphery (each side) of the rectangular range of the waveguide portion 11. The gap between the slotted through holes 12 (the through holes 120) next to each other in a direction along the waveguide portion 11 is basically sufficiently small. For example, the distance of the largest gap may be smaller than or equal to one-tenth of the wavelength of the target electromagnetic waves that propagate in the waveguide portion 11, and this configuration effectively reduces the leakage of the electromagnetic waves through the gaps. The frequency range used in this embodiment is approximately 28 to 60 GHz, and the distance of the gaps is approximately 0.5 to 1.1 mm. Note that the distances of all the gaps need not be the same due to the convenience of arrangement. If the distances of the gaps are partially smaller than or equal to one-tenth of the wavelength of the target electromagnetic waves that propagate, portions wider than those gaps may be present.

Furthermore, in an embodiment, the slotted through holes 12 may surround the periphery of the waveguide portion 11 in three layers. Of the three layers, the gap positions of an innermost (a first layer) shield structure set L1 and the gap positions of a shield structure set L2 on the outer side (a second layer and a third layer) are different in the direction parallel to each side of the waveguide portion 11. With this, the electromagnetic wave having leaked through the gaps of the shield structure set L1 in the first layer, further leaking to the outside is reduced by the shield structure set L2 in the second and third layers. As described above, this structure sufficiently reduces the leakage of electromagnetic waves from the waveguide portion 11.

A method for manufacturing the slotted through hole 12 described above will be described.

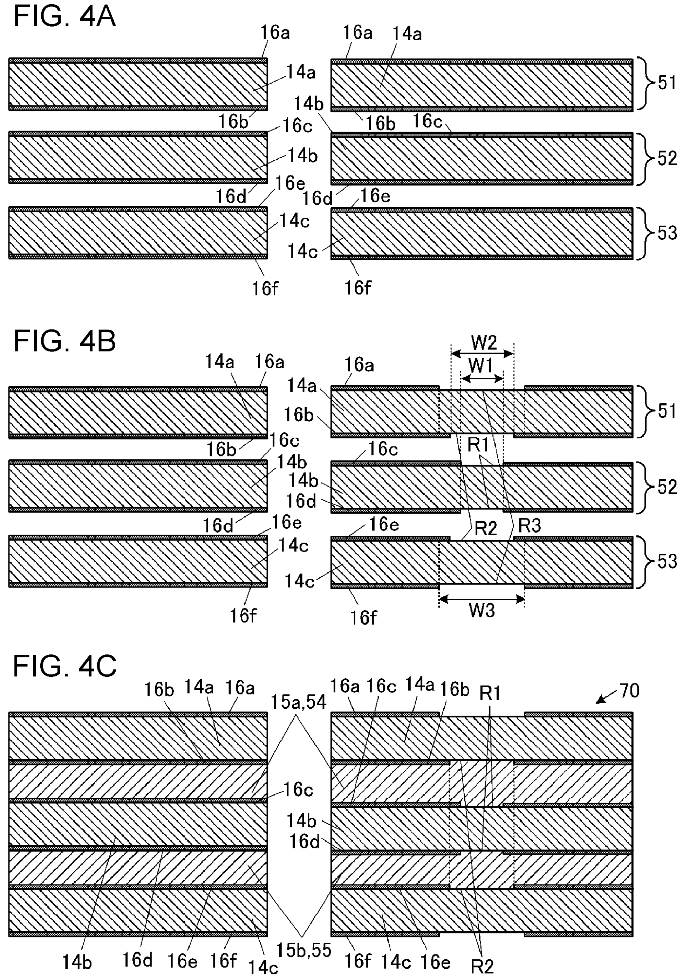

The slotted through hole 12 is obtained in the manufacturing steps of the core substrate 10 of the printed wiring board (the phased array antenna board 100). As described above, the core substrate 10 includes the multiple stacked insulating layers 14a to 14c, 15a, and 15b and the conductor layers 16a to 16f located between the insulating layers 14a to 14c, 15a, and 15b and on the surfaces. These are formed by using, for example, substrates 50 each including an insulating layer and conductor layers such as copper foils or the like attached on both sides and prepregs 54 and 55 which are insulating layers in a semi-cured state (see FIG. 4C and other figures).

FIGs. 4A to 4C, 5A to 5C, and 6A to 6C are diagrams for explaining the procedure of a first method for manufacturing the slotted through hole 12 (the core substrate 10).

In each figure, the left diagram illustrates a cross section in the end portions 120a and 120c, taken along cross-section lines BB and CC perpendicular to the elongation direction of the slotted hole (the X direction), and the right diagram illustrates a cross section in the intermediate portion 120b, taken along cross-section line AA perpendicular to the elongation direction of the slotted hole (the X direction).

As illustrated in FIG. 4A, multiple substrates 50, in this case, three substrates 51 to 53, are prepared. The substrate 51 includes the insulating layer 14a (a second insulating plate) and conductor layers 16a and 16b (respectively corresponding to a third conductor layer on the side opposite to a second conductor layer, and the second conductor layer), which are copper foils attached to (covering) both upper and lower surfaces of the insulating layer 14a. The substrate 52 includes the insulating layer 14b (a first insulating plate) and conductor layers 16c and 16d (first conductor layers), which are copper foils attached to both upper and lower surfaces of the insulating layer 14b. The substrate 53 includes the insulating layer 14c (a second insulating plate) and conductor layers 16e and 16f (respectively corresponding to a second conductor layer and a third conductor layer on the side opposite to the second conductor layer), which are copper foils attached to both upper and lower surfaces of the insulating layer 14c.

As illustrated in FIG. 4B, the ranges of the conductor layers 16a to 16f, corresponding to the intermediate portion 120b (in other words, in the same position in transparent plan view) are removed by etching. In this process, in the cross-sectional view taken along cross-section line AA, a first width W1 of first regions R1 of the substrate 52, which are removal ranges of the conductor layers 16c and 16d, is smaller than a second width W2 of second regions R2 of the other two substrates 51 and 53, which are removal ranges of the conductor layers 16b and 16e, and a third width W3 of third regions R3, which are removal regions of the conductor layers 16a and 16f. In addition, the second width W2 is smaller than the third width W3. In transparent plan view, the second regions R2 have a size that encompasses the first regions R1, and the third regions R3 have a size that encompasses the second regions R2. In transparent plan view, the positional relationship between the third regions R3 and the second regions R2 is such that the third regions R3 encompass the second regions R2.

As illustrated in FIG. 4C, the three substrates 51 to 53 are joined with the prepregs 54 and 55 in between by thermocompression using a lamination press to form a multilayer body 70. Specifically, the conductor layer 16b faces the conductor layer 16c with the insulating layer 15a in between, and the conductor layer 16e faces the conductor layer 16d with the insulating layer 15b in between. In this process, the lamination is performed such that the positional relationship of the second regions R2 encompassing the first regions R1 in transparent plan view is kept, in particular, the positional relationship in which the center positions of the first regions R1 in the width direction coincide with the center positions of the second regions R2 in the width direction is kept. Thus, in the multilayer body 70, the dimension of the first width W1 to the third width W3 decreases in order from the outer sides of the multilayer body 70 (the upper surface side and the lower surface side) toward the center in the through-thickness direction of the through hole.

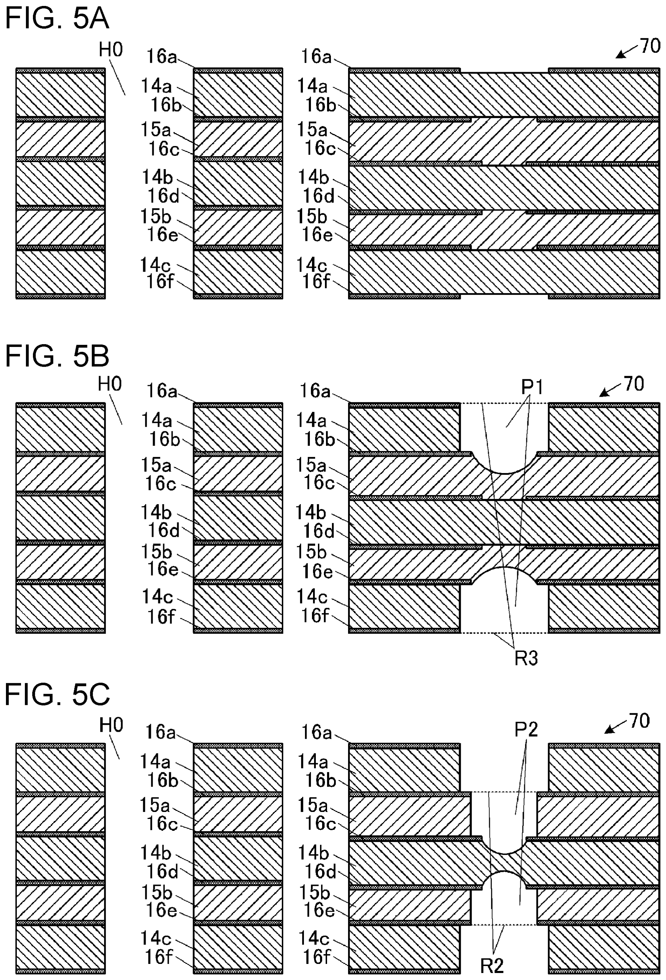

As illustrated in FIG. 5A, through holes H0 are formed by drilling at positions corresponding to the end portions 120a and 120c of the multilayer body 70 (the both ends of the third regions R3). These through holes H0 overlap both ends, in the elongation direction of the slotted hole, of the first regions R1 to the third regions R3 which are the removal ranges mentioned above.

As illustrated in FIG. 5B, holes P1 (first holes) are formed by performing laser processing on the insulating layers 14a and 14c in (in accordance with) the ranges of the third regions R3 of the multilayer body 70. Since the diameter of laser processing is smaller than the through hole H0 formed by drilling, the holes P1 are formed by performing laser processing multiple times along the outer periphery of the intermediate portion 120b. This process exposes the second regions R2 and the conductor layers 16b and 16e around the second regions R2.

As illustrated in FIG. 5C, holes P2 (second holes) are formed by performing laser processing on the insulating layers 15a and 15b in (in accordance with) the ranges of the second regions R2 of the multilayer body 70. This process exposes the first regions R1 and the conductor layers 16c and 16d around the first regions R1.

As illustrated in FIG. 6A, a hole P3 (a third hole) is formed by performing laser processing on the insulating layer 14b in (in accordance with) the range of the exposed first regions R1. Thus, the through hole 120 extending through the entire multilayer body 70 is obtained. In the through hole 120, the end portion 120a includes side walls (second side walls) having parallel straight line shapes (line shapes facing each other) and facing each other, and the intermediate portion 120b includes side walls (first side walls) on both sides, having stepped shapes and facing each other.

As illustrated in FIG. 6B, the through-hole conductor 121 is attached along the inner side surface of the through hole 120 (the end portions 120a and 120c and the intermediate portion 120b). The through-hole conductor 121 is formed by, for example, electroless copper plating and electrolytic copper plating. Next, as illustrated in FIG. 6C, the inner side of the through-hole conductor 121 inside the through hole 120 is filled with a resin to form the insulating resin 122. Thus, the slotted through hole 12 is obtained in which the intermediate portion 120b includes stepped side wall surfaces.

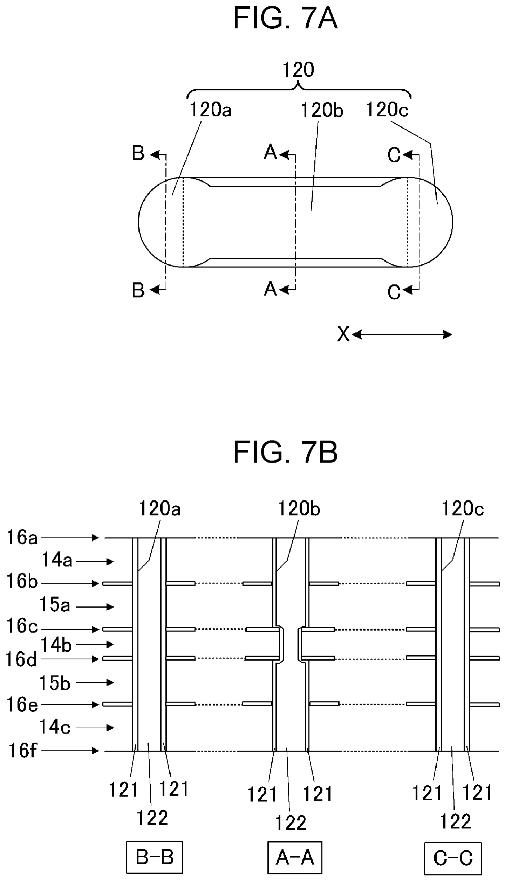

FIG. 7A is a plan view of a through hole 120 of a second example. FIG. 7B illustrates cross-sectional views of a through-hole conductor 121 provided in this plan view (the through hole 120), taken along cross-section lines AA, BB, and CC.

In this slotted through hole 12, the stepped shapes of the side walls of the intermediate portion 120b need not have steps at the positions of all the conductor layers 16. This example illustrates stepped shapes having steps only at the positions of the conductor layers 16c and 16d located on both sides of the insulating layer 14b.

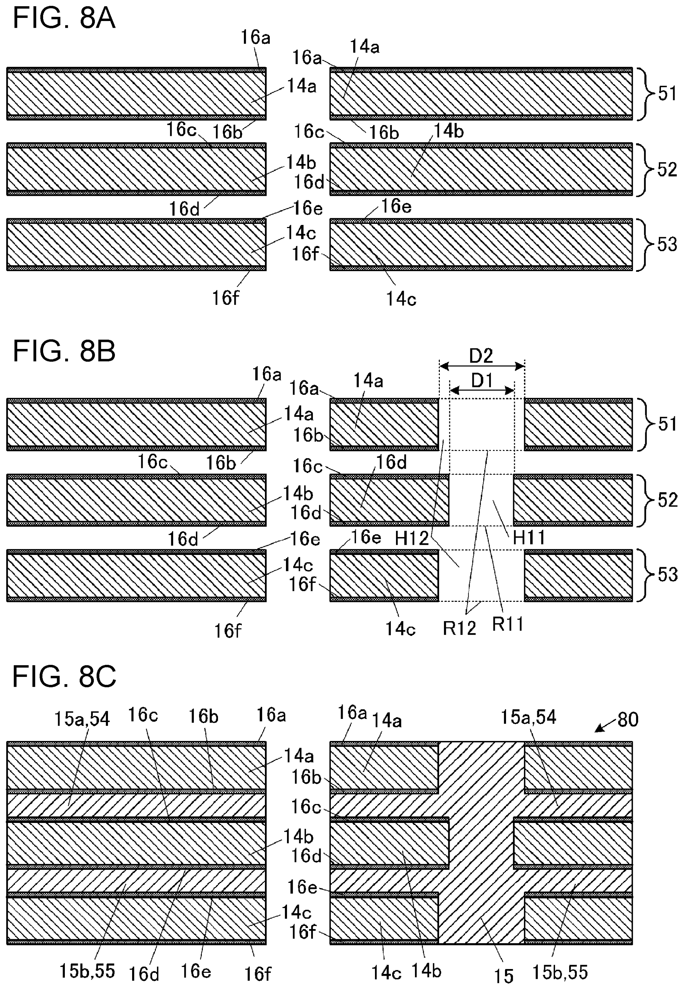

FIGs. 8A to 8C, 9A to 9C, 10A, and 10B are diagrams for explaining the procedure of a second method for manufacturing the slotted through hole 12 (the core substrate 10).

As illustrated in FIG. 8A, substrates 51 to 53 are prepared. The substrates 51 to 53 are the same as those illustrated in FIG. 4A, and hence, description thereof is omitted.

As illustrated in FIG. 8B, a through hole H12 (a second through hole) is formed in the substrates 51 and 53 by drilling in a region R12 corresponding to the intermediate portion 120b and having a slotted hole shape with a second width D2. In addition, a through hole H11 (a first through hole) is formed in the substrate 52 by drilling in a region R11 having a slotted hole shape with a first width D1 smaller than that of the through hole H12. A method including etching or a method including drilling can be selected depending on the thickness of each substrate 50.

As illustrated in FIG. 8C, the substrates 51 to 53 are stacked such that the conductor layer 16b faces the conductor layer 16c with a prepreg 54 in between, which will become the insulating layer 15a, and that the conductor layer 16e faces the conductor layer 16d with a prepreg 55 in between, which will become the insulating layer 15b, and the substrates 51 to 53 are joined by thermocompression using a lamination press to form a multilayer body 80. In this process, part of the insulating layers 15 fill the entire inside of the through holes H11 and H12 formed in the process mentioned above. This process is performed in a state in which the positional relationship of the through holes H12 encompassing the through hole H11 in transparent plan view is kept.

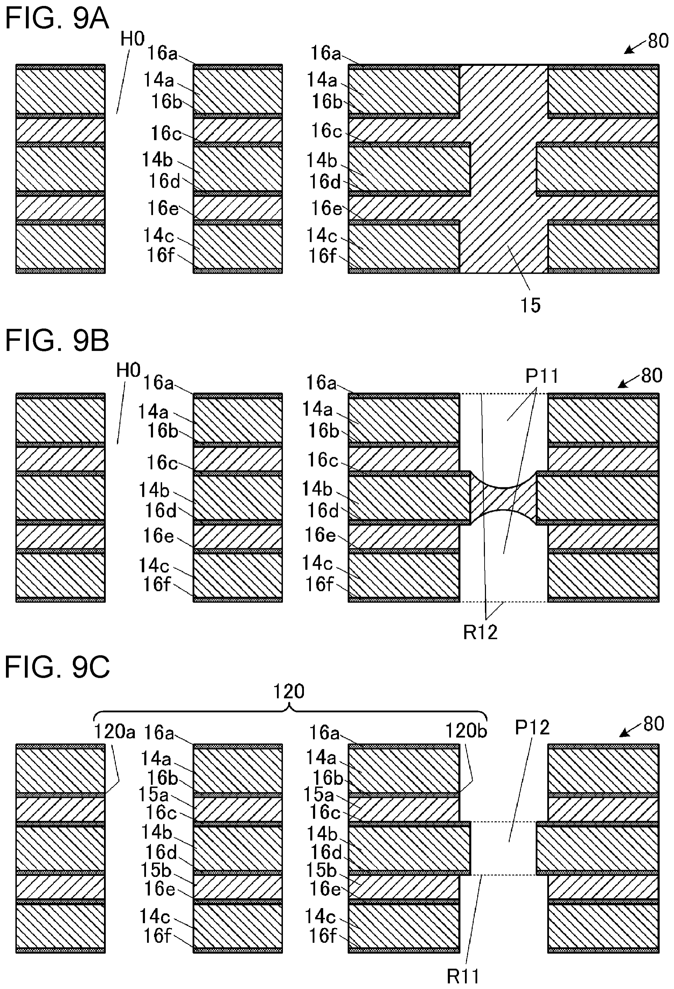

As illustrated in FIG. 9A, through holes H0 (third through holes) are formed by drilling at the positions corresponding to the end portions 120a and 120c in the multilayer body 80 (at both ends of the through hole H12). These through holes H0 overlap both ends in the elongation direction of the through holes H11 and H12 which are filled with part of the insulating layers 15.

As illustrated in FIG. 9B, holes P11 (first holes) are formed by removing the insulating layer 14a and the insulating layer 14c by laser in (in accordance with) regions R12 from each surface of the core substrate 10 until the conductor layers 16c and 16d are exposed. In this process, the side surfaces of the end portions of the conductor layers 16b and 16e are exposed on the side walls of the holes P11, and parts of the insulating layer 14b are removed.

As illustrated in FIG. 9C, a hole P12 (a second hole) is formed by removing part of the insulating layers 15 in the through hole H11 by laser in (in accordance with) the region R11. Thus, a through hole 120 extending through the multilayer body 80 is obtained. The side walls of the end portion 120a are in straight line shapes in a cross-sectional view, and the side walls of the intermediate portion 120b are in stepped shapes (one step) in a cross-sectional view.

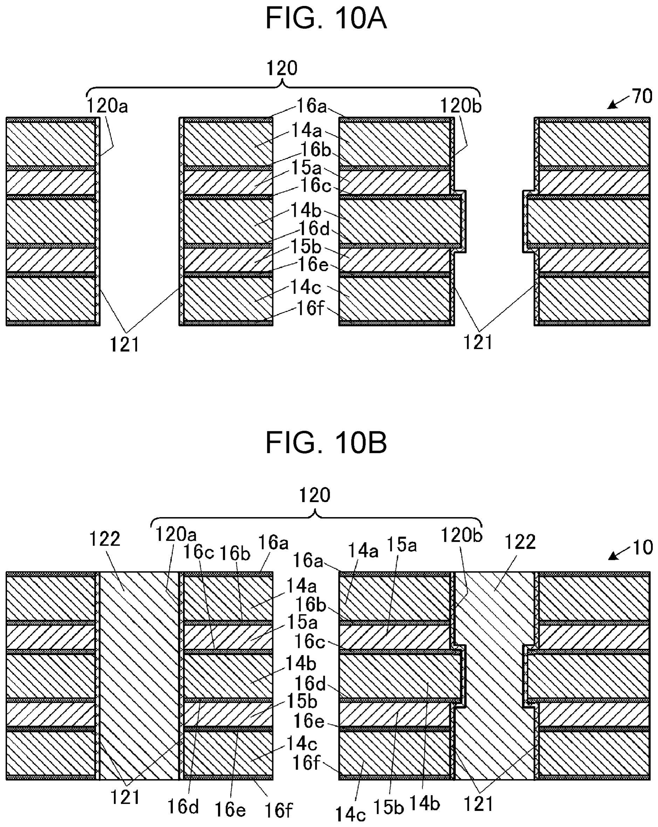

As illustrated in FIG. 10A, the through-hole conductor 121 is attached along the inner surface of the through hole 120. The through-hole conductor 121 is formed by, for example, electroless copper plating and electrolytic copper plating.

As illustrated in FIG. 10B, the inside of the through hole 120 is filled with an insulating material (a resin) to form the insulating resin 122, and thus, the slotted through hole 12 is obtained.

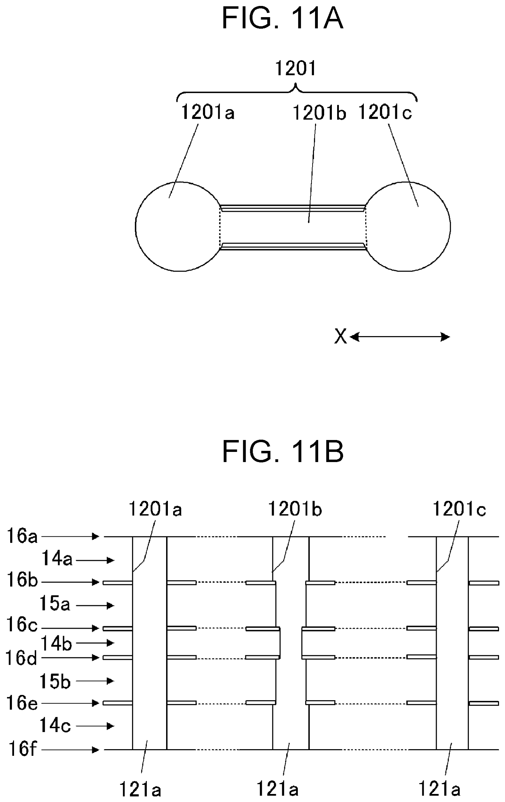

FIG. 11A is a plan view of a through hole 120 of a third example. FIG. 11B illustrates cross-sectional views of a through-hole conductor 121a provided in a through hole 120 of a fourth example.

As in the third example illustrated in FIG. 11A, in the slotted through hole 12, the width of an intermediate portion 1201b in the direction perpendicular to the longitudinal direction of a through hole 1201 in plan view may be smaller than the largest width of end portions 1201a and 1201c in the same direction. Also with such a shape, the intermediate portion 1201b, for example, needs only to have a minimum necessary width to maintain the strength as the slotted through hole 12.

As in the fourth example illustrated in FIG. 11B, the slotted through hole 12 may have a through-hole conductor 121a throughout the entire inside of the through hole 120. In other words, a slotted through hole 12 can be obtained without an insulating resin 122 composed of a resin or the like.

Note that the insulating resin 122 is not an indispensable component for the slotted through hole 12 and is used for filling as necessary.

As described above, in the present embodiment, the printed wiring board includes the core substrate 10 including the through holes 120 in slotted hole shapes in plan view and the through-hole conductors 121 located in the through holes 120. Each through hole 120 includes the paired end portions 120a and 120c located at both ends of the through hole 120 in the longitudinal direction in plan view and the intermediate portion 120b located between the paired end portions 120a and 120c. The intermediate portion 120b includes, at least in part in the longitudinal direction, the first side walls of the through hole 120 having stepped shapes facing each other in a cross-sectional view perpendicular to the longitudinal direction, and the distance between the first side walls facing each other decreases as the distance to the center of the core substrate 10 in the thickness direction decreases in the through-thickness direction of the through hole 120.

In this printed wiring board, each of the conductor layers 16a to 16f is more likely to be in contact with the through-hole conductor 121. Hence, this printed wiring board makes it possible to transmit electromagnetic waves more reliably and reduce the leakage of electromagnetic waves from the shield structure 12S.

In a cross-sectional view perpendicular to the longitudinal direction of the through hole 120, each of the end portions 120a and 120c may include the side walls (the second side walls) of the through hole 120 in line shapes facing each other. Hence, although the end portions 120a and 120c of the through hole 120 do not have significantly special shapes, they appropriately function as both ends of the shield structure 12S.

In a cross-sectional view perpendicular to the longitudinal direction of the through hole 120, each of the end portions 120a and 120c may include the side walls (the second side walls) of the through hole 120 in straight line shapes parallel to each other. As described above, unlike the intermediate portion 120b, the end portions 120a and 120c have side walls without stepped shapes. Since through holes can be formed at both ends by drilling as in a standard process unlike the straight line shape portion (the intermediate portion 120b) of the slotted hole, both ends need not have characteristic shapes.

In plan view, the largest distance between the side walls of the end portions 120a and 120c facing each other in the width direction may be larger than or equal to the largest distance between the side walls of the intermediate portion 120b facing each other in the width direction perpendicular to the longitudinal direction of the slotted hole. In other words, the end portions 120a and 120c may have such a shape that a large width continues toward both ends of the through hole 120, such as a trapezoid or a rectangle in plan view. In other words, the end portions 120a and 120c are not limited to being circular in plan view and need only to have shapes that can be easily formed by drilling.

The core substrate 10 may include the multiple stacked insulating layers 14a to 14c, 15a, and 15b and the multiple conductor layers 16b to 16e each located between two insulating layers adjacent to each other of these insulating layers. In the intermediate portion 120b, the multiple insulating layers 14a to 14c, 15a, and 15b include the insulating layer 14b and the like at least including the protruding regions Q protruding from the opening edges of the through hole 120 toward the center in plan view. The multiple conductor layers 16b to 16e include at least the conductor layers 16c and 16d and the like extending from between the multiple insulating layers 14a to 14c, 15a, and 15b to the protruding regions Q, and these conductor layers 16c and 16d and the like are electrically connected to the through-hole conductor 121 in the protruding regions Q.

Specifically, since the conductor layers 16b to 16e, which are the inner layers of the core substrate 10, are exposed not only at the side surfaces of the edges but also in wider ranges as described above, the through-hole conductor 121 is reliably in contact with and electrically connected to the conductor layers 16b to 16e. This extends the ground plane appropriately, reduces the loss of electromagnetic waves, and reduces the leakage of electromagnetic waves.

The multiple insulating layers 14a to 14c, 15a, and 15b may include the multiple insulating layers14b, 15a, and 15b including the protruding regions Q having different protrusion widths from the opening edges of the through hole 120 toward the center in plan view in the intermediate portion 120b. The multiple conductor layers 16b to 16e may include the multiple conductor layers 16b to 16e extending from between the multiple insulating layers 14a to 14c, 15a, and 15b to the protruding regions Q, and these multiple conductor layers 16b to 16e may be electrically connected to the through-hole conductor 121 in the protruding regions Q. Since the protrusion width is different for each insulating layer as described above, the conductor layers 16b to 16e between the insulating layers can be exposed more reliably. Thus, in the printed wiring board, the through-hole conductor 121 is reliably connected to each of the conductor layers 16b to 16e, and this reduces the leakage of electromagnetic waves and enables electromagnetic waves to propagate appropriately.

The multiple conductor layers 16b to 16e may be ground conductor layers that are connected to a ground plane at the time of use. Hence, the through-hole conductor 121 is also appropriately grounded.

The core substrate 10 may include multiple through holes 120, each of which may have the through-hole conductor 121. The intermediate portion 120b of each through hole 120 may have a straight line shape in plan view. The printed wiring board may have a waveguide tube structure in which the multiple through holes 120 are aligned to surround the waveguide portion 11, which is a rectangular range of the core substrate 10 in plan view.

Since the waveguide portion 11 is surrounded by the through holes 120 having slotted hole shapes in plan view as described above, the gaps between the through holes adjacent to each other can be reduced, compared with, for example, circular through holes in plan view. This reliably reduces the leakage of electromagnetic waves.

The multiple through holes 120 may be located such that each intermediate portion 120b is along the corresponding side of the waveguide portion 11. Specifically, a longitudinal side of the through hole 120 faces the waveguide portion 11, and the through hole 120 functions as a shield in a long range. Thus, the leakage of electromagnetic waves can be reduced efficiently and more reliably.

The distance between through holes 120 adjacent to each other in the direction parallel to each side of the waveguide portion 11 may be smaller than or equal to one-tenth of the wavelength of electromagnetic waves that propagate in the waveguide portion 11. The target electromagnetic waves that propagate are less likely to leak through gaps small enough for the wavelength. In particular, gaps smaller than or equal to one-tenth of the wavelength significantly reduce the leakage of electromagnetic waves. Hence, with the structure having the multiple through holes 120 aligned to have such gap distances, the waveguide tube structure of the printed wiring board enables electromagnetic wave to propagate appropriately.

The through-hole conductor 121 may be located along the approximately entire side walls of the through hole 120 including the side walls of the intermediate portion 120b, and the insulating resin 122 may be located on the inner side of the through-hole conductor 121. The structure mentioned above improves the reliability of the printed wiring board and efficiently reduces the leakage of electromagnetic waves.

Alternatively, the through-hole conductor layer 121a may be located throughout the entire inside of the through hole 120. In other words, the through hole 120 may be filled with the through-hole conductor layer 121a.

The first method for manufacturing the printed wiring board of the present embodiment includes the following steps: removing coverings of the conductor layers 16c and 16d from the insulating layer 14b covered with the conductor layers 16c and 16d on both sides, in the first regions R1 having the first width W1 and elongated in the same position in transparent plan view; removing coverings of the conductor layers 16b and 16e from the two insulating layers 14a and 14c, each having one surface covered with the conductor layer 16b or 16e and the surface opposite to the one surface, covered with the conductor layer 16a or 16f, in the elongated second regions R2 having the second width W2 larger than the first width W1; removing coverings of the conductor layers 16a and 16f from the insulating layers 14a and 14c, in the third regions R3 having the third width W3 larger than the second width W2 and encompassing the second regions R2 in transparent plan view; forming the multilayer body 70 by joining the conductor layers 16b and 16e to the conductor layers 16c and 16d with the insulating layers 15a and 15b in between, respectively, in a state in which the positional relationship of the second regions R2 encompassing the first regions R1 in transparent plan view is kept; forming the through holes H0 by drilling at both ends of the third regions R3 in the multilayer body 70; forming the holes P1 that extend through the insulating layers 14a and 14c by laser in accordance with the third regions R3; forming the holes P2 that extend through the insulating layers 15a and 15b by laser in accordance with the second regions R2; forming the hole P3 that extends through the insulating layer 14b by laser in accordance with the first regions R1; and attaching the through-hole conductor 121 to the holes P1, the holes P2, and the hole P3.

As described above, in the first manufacturing method, parts of the conductor layers at the positions where the slotted through hole 12 is to be formed are first removed in the first regions R1 to the third regions R3 whose widths decrease as the distance to the center decreases. Then, holes are formed by laser in order until the conductor layers of the inner layer are exposed in accordance with each region. Hence, the conductor layers 16b to 16e between the insulating layers are reliably exposed. Thus, in the printed wiring board, the exposed conductor layers 16b to 16e can be reliably connected to the through-hole conductor 121. Thus, this printed wiring board reduces the leakage and loss of electromagnetic waves and enables electromagnetic waves to propagate appropriately.

The second method for manufacturing the printed wiring board includes the following steps: forming the elongated through hole H11 having the first width D1 by drilling in the insulating layer 14b covered with the conductor layers 16c and 16d on both sides: forming the elongated through hole H12 having the second width D2 larger than the first width D1 by drilling in the two insulating layers 14a and 14c each covered with the conductor layer 16a, 16b, 16e, or 16f on both sides: forming the multilayer body 80 by joining the conductor layers 16b and 16e to the conductor layers 16c and 16d with the insulating layers 15a and 15b in between, respectively, such that the positional relationship of the through holes H12 encompassing the through hole H11 in transparent plan view is kept and that the insulating layers 15a and 15b fill the inside of the through hole H11 and the insides of the through holes H12: forming the through holes H0 by drilling at both ends of the through hole H12 in the multilayer body 80: forming the holes P11 each of which extends through the insulating layer 14a or 14b and the insulating layer 15a or 15b by laser in accordance with the regions R12 of the through holes H12: forming the hole P12 that extends through the insulating layer 14b (the insulating layer embedded in the insulating layer 14b) by laser in accordance with the region R11 of the through hole H11; and attaching the through-hole conductor 121 to the holes P11, the hole P12, and the through holes H0.

As described above, after a through hole is once formed in each substrate at the position corresponding to the position of the slotted hole, the through holes are backfilled when the joining is performed. Thus, the regions not including conductor layers are obtained. These portions are cut again by laser so that the through holes with a slotted hole shape is formed. Thus, the through hole with an appropriate shape can be obtained. This configuration enables the conductor layers 16b to 16e to be appropriately joined to the through-hole conductor 121. Hence, the printed wiring board obtained through this manufacturing method appropriately reduces the leakage of electromagnetic waves and enables electromagnetic waves to propagate with low loss.

Note that the embodiments described above are examples and can be changed in various manners.

For example, although the description of the above embodiments is based on a printed wiring board including five insulating layers obtained by joining the three substrates 51 to 53 with insulating layers in between, the present disclosure is not limited to this. The present disclosure is also applicable to a printed wiring board (a core substrate 10) obtained by further joining substrates to the outer sides of the substrates 51 and 53 with insulating layers in between.

Although the description of the above embodiments is based on the assumption that the intermediate portion 120b has a straight line (rectangular) shape in plan view, the present disclosure is not limited to this. The intermediate portion 120b may be curved or angled at an intermediate position. Of the multiple slotted through holes 12, only some of them may have an intermediate portion 120b curved or angled at an intermediate position. In addition, the width of the intermediate portion 120b of the through hole 120 in the direction perpendicular to the longitudinal direction in plan view is not limited to being constant. In this case, the intermediate portion 120b may include a portion whose width is larger than the largest value of the widths of the end portions 120a and 120c in the above-mentioned elongation direction.

The present disclosure is not limited to the intermediate portion 120b within the range of which the entire side walls have stepped shapes. Parts of the side walls may have inclined surfaces where the corners of straight lines or step portions are eliminated in a cross-sectional view.

The side wall surfaces of the end portions 120a and 120c are not limited to having straight line shapes in cross-sectional views. For example, they may be curved at an intermediate position.

Although the description of the above embodiments is based on the assumption that the through-hole conductor 121 is in contact with all the conductor layers 16a to 16f between the insulating layers, the present disclosure is not limited to this. A configuration in which some of the conductor layers are not in contact with (not electrically connected to) the through-hole conductor 121 is possible. Although the above description is based only on a cross-sectional view, a configuration in which each conductor layer is partially in contact with the through-hole conductor 121 in the elongation direction of the slotted hole is possible.

The printed wiring board (the core substrate 10) may be obtained by a manufacturing method other than the above-mentioned first and second manufacturing methods.

In addition, the specific configurations, structures, materials, sizes, manufacturing procedure, and the like described in the above embodiments can be changed as appropriate within a range not departing from the spirit of the present invention. The scope of the present invention includes the scope of the invention recited in the claims and the equivalents thereof.

### INDUSTRIAL APPLICABILITY

The present disclosure can be used for printed wiring boards and methods of manufacturing printed wiring boards.

### REFERENCE SIGNS

- 10: core substrate
- 11: waveguide portion
- 12: slotted through hole
- 12S: shield structure
- 14a to 14c, 15a, 15b: insulating layer
- 16a to 16f: conductor layer
- 21: resonator
- 22: conductor via
- 31: emission pad
- 50, 51 to 53: substrate
- 54, 55: prepreg
- 70, 80: multilayer body
- 100: phased array antenna board
- 100a: patch antenna
- 120: through hole
- 120a, 120c: end portion
- 120b: intermediate portion
- 121, 121a: through-hole conductor
- 122: insulating resin
- 1201: through hole
- 1201a, 1201c: end portion
- 1201b: intermediate portion
- H0, H11, H12: through hole
- L1, L2: shield structure set
- P1 to P3, P11, P12: hole
- Q: protruding region
- R1: first region
- R2: second region
- R3: third region
- R11, R12: region
- W1: first width
- W2: second width
- W3: third width

## Claims

1. A printed wiring board comprising:
a core substrate comprising a through hole in a slotted hole shape in plan view; and
a through conductor located in the through hole, wherein
the through hole comprises:
pared end portions located at both ends of the through hole in a longitudinal direction of the through hole in plan view; and
an intermediate portion located between the paired end portions,
the intermediate portion comprises, at least in part in the longitudinal direction, first side walls having stepped shapes facing each other in a cross-sectional view perpendicular to the longitudinal direction, and
a distance between the first side walls facing each other decreases as a distance to a center of the core substrate in a thickness direction decreases in a through-thickness direction of the through hole.

2. The printed wiring board according to claim 1, wherein
each of the end portions comprises second side walls having line shapes facing each other in a cross-sectional view perpendicular to the longitudinal direction.

3. The printed wiring board according to claim 1 or 2, wherein
each of the end portions comprises second side walls of the through hole in a cross-sectional view perpendicular to the longitudinal direction, the second side walls having straight line shapes parallel to each other.

4. The printed wiring board according to claim 2 or 3, wherein
in plan view, a largest distance between the second side walls facing each other is larger than or equal to a largest distance between the first side walls facing each other.

5. The printed wiring board according to any one of claims 1 to 4, wherein
the core substrate comprises:
multiple stacked insulating layers; and
multiple conductor layers each being between two insulating layers adjacent to each other of the multiple insulating layers,
the multiple insulating layers comprise a first insulating layer comprising, in the intermediate portion, at least a first protruding region protruding from an opening edge of the through hole toward a center of the through hole in plan view,
the multiple conductor layers comprise at least a first conductor layer extending on the first insulating layer from between the first insulating layer and an insulating layer adjacent to the first insulating layer to the first protruding region, and
the first conductor layer is electrically connected to the through conductor in the first protruding region.

6. The printed wiring board according to claim 5, wherein
the multiple insulating layers comprise, in the intermediate portion, a plurality of insulating layers comprising protruding regions having different protrusion widths from the opening edge of the through hole toward a center of the through hole in plan view,
the multiple conductor layers comprise a plurality of conductor layers extending from between the multiple insulating layers to the protruding regions, and
the plurality of conductor layers is electrically connected to the through conductor in the protruding regions.

7. The printed wiring board according to claim 5 or 6, wherein
the multiple conductor layers are ground conductor layers.

8. The printed wiring board according to any one of claims 1 to 7, wherein
the core substrate comprises a plurality of the through holes,
each of the through holes has the through conductor,
the intermediate portion has a straight line shape in plan view, and
the through holes are aligned and surround a rectangular range of the core substrate in plan view and form a waveguide tube structure.

9. The printed wiring board according to claim 8, wherein
the intermediate portion of each of the through holes is along a corresponding side of the range.

10. The printed wiring board according to claim 9, wherein
a distance between adjacent ones of the through holes in a direction parallel to the corresponding side is smaller than or equal to one-tenth of a wavelength of an electromagnetic wave that propagates in the range.

11. The printed wiring board according to any one of claims 1 to 10, wherein
the through conductor is located along a side wall of the through hole, the side wall including the first side walls, and
an insulating resin is located on an inner side of the through conductor.

12. The printed wiring board according to any one of claims 1 to 11, wherein
the through conductor is located throughout an entire inside of the through hole.

13. A method for manufacturing a printed wiring board, comprising:
removing, from a first insulating plate covered with first conductor layers on both sides, coverings of the first conductor layers, in first regions having a first width and elongated in a same position in transparent plan view;
removing, from two second insulating plates each comprising one surface covered with a second conductor layer and a surface opposite to the one surface and covered with a third conductor layer, coverings of the second conductor layers, in elongated second regions having a second width larger than the first width;
removing coverings of the third conductor layers from the two second insulating plates, in third regions having a third width larger than the second width and encompassing the second regions in transparent plan view;
forming a multilayer body by joining each of the second conductor layers to one of the first conductor layers with an insulating layer in between in a state in which a positional relationship of the second regions encompassing the first regions in transparent plan view is kept;
forming through holes by drilling at both ends of the third regions in the multilayer body;
forming first holes that extend through the second insulating plates by laser in accordance with the third regions;
forming second holes that extend through the insulating layers by laser in accordance with the second regions;
forming a third hole that extends through the first insulating plate by laser in accordance with the first regions; and
attaching a through conductor to the first holes, the second holes, the third hole, and the through holes.

14. A method for manufacturing a printed wiring board, comprising:
forming an elongated first through hole having a first width by drilling in a first insulating plate covered with first conductor layers on both sides;
forming an elongated second through hole having a second width larger than the first width by drilling in each of two second insulating plates each covered with second conductor layers on both sides;
forming a multilayer body by joining one of the second conductor layers of each second insulating plate to one of the first conductor layers with an insulating layer in between, in a state in which a positional relationship of the second through holes encompassing the first through hole in transparent plan view is kept, and filling an inside of the first through hole and insides of the second through holes with the insulating layer;
forming third through holes in the multilayer body by drilling at both ends of the second through holes;
forming first holes that extend through the second insulating plates and the insulating layers by laser in accordance with ranges of the second through holes;
forming a second hole that extends through the first insulating plate by laser in accordance with a range of the first through hole; and
attaching a through conductor to the first holes, the second hole, and the third through holes.
